# EUROPÄISCHE PATENTSCHRIFT

(11) **EP 3 640 652 B1**
(45) Veröffentlichungstag und Bekanntmachung des Hinweises auf die Patenterteilung: **29.03.2023**
(21) Anmeldenummer: 19202621.9
(22) Anmeldetag: 11.10.2019
(51) Int. Cl.: G01R 19/32, G01R 31/382, G01R 31/385, G01R 35/00, G01R 31/3842

(54) **VERFAHREN ZUM BETRIEB EINES BATTERIESENSORS UND BATTERIESENSOR**
BATTERY SENSOR AND METHOD FOR OPERATING SAME
PROCÉDÉ DE FONCTIONNEMENT D'UN CAPTEUR DE BATTERIE ET CAPTEUR DE BATTERIE

(30) Priorität: 15.10.2018 DE 102018217625
(43) Veröffentlichungstag der Anmeldung: 22.04.2020
(73) Patentinhaber: Continental Automotive Technologies GmbH, 30165 Hannover (DE)
(72) Erfinder: Frenzel, Henryk, 60488 Frankfurt am Main (DE); Schramme, Martin, 60488 Frankfurt am Main (DE)
(74) Vertreter: Continental Corporation

(56) Entgegenhaltungen:
- WO-A1-2012/098968
- WO-A1-2017/140874
- WO-A1-2018/162021
- WO-A1-2019/081365
- CN-A- 106 249 186
- CN-A- 108 287 310
- DE-A1-102004 062 655
- DE-A1-102010 001 529
- DE-A1-102015 217 862
- DE-A1-102016 204 941
- DE-A1-102017 203 535
- JP-A- 2001 110 459
- US-A1- 2006 117 194
- US-A1- 2018 149 705

## Beschreibung

Batteriesensoren werden in Fahrzeugen zur Erfassung von Batterieparametern der Fahrzeugbatterie verwendet, um Aussagen über den Batteriezustand, beispielsweise den Ladezustand der Batterie, treffen zu können. Die zu erfassenden Batterieparameter sind beispielsweise die Batteriespannung, der Batteriestrom und die Temperatur der Batterie, wobei insbesondere die Batteriespannung und der Batteriestrom permanent erfasst werden müssen, um beispielsweise eine exakte Aussage über den Ladezustand der Batterie treffen zu können.

Um eine möglichst exakte Aussage über den Batteriezustand treffen zu können, ist eine hohe Genauigkeit der Erfassungseinrichtungen für die Batterieparameter erforderlich. Die Genauigkeit der Erfassungseinrichtungen hängt aber von vielen Faktoren ab. Beispielsweise kann sich die aktuelle Umgebungstemperatur oder die aktuelle Batterietemperatur auf die Messgenauigkeit auswirken, da ein elektrischer Widerstand eines Messwiderstandes einer Erfassungseinrichtung temperaturabhängig sein kann. Des Weiteren kann es über die Lebensdauer des Batteriesensors zu Alterungserscheinungen kommen, die sich ebenfalls auf die Messgenauigkeit auswirken. Darüber hinaus können einzelne Ereignisse, beispielsweise hohe Lastspitzen oder mechanische Belastungen die Messgenauigkeit beeinflussen.

Um die Messgenauigkeit möglichst hoch zu halten, wird versucht, die Komponenten bzw. deren Material so auszuwählen, dass die mögliche Gesamtabweichung des Batteriesensors, die sich aus den möglichen Abweichungen der einzelnen Komponenten zusammensetzt, innerhalb der geforderten Toleranzen bleibt.

Grundsätzlich ist des Weiteren bekannt, dass Veränderungen der Eigenschaften der Komponenten, beispielsweise eine altersbedingte Änderung des elektrischen Widerstandes, zu Beginn der Lebensdauer, also im Neuzustand, am größten ist. Mit zunehmender Lebensdauer konvergieren die Eigenschaften der Komponenten zu einem Endwert. Aus diesem Grund werden Komponenten häufig vor dem Einbau einer Voralterung unterzogen, das heißt, vor dem Einbau werden die Komponenten so belastet, dass ein Großteil der Alterung bereits vor dem Einbau der Komponente erfolgt ist. Dies ist aber sehr zeitaufwendig und kostenintensiv. Zudem ist die Geschwindigkeit der Alterung auch von der Nutzung bzw. der Belastung im Fahrzeug abhängig. Hohe Ströme oder extreme Temperaturen führen beispielsweise zu einer schnelleren Alterung. Auch bei einer Voralterung ist somit schwer abschätzbar, wie sich die Alterung der Komponenten des Batteriesensors im Betrieb des Fahrzeugs entwickelt.

Die WO 2017/014874 A1 zeigt einen Batteriesensor, bei welchem eine Spannung über einem Messwiderstand bei alternierender Parallelschaltung eines Referenzwiderstands gemessen wird.

Die DE 10 2016 204941 A1 zeigt ein Verfahren zum Bestimmen eines Laststroms, wobei eine Messwiderstandsgruppe verwendet wird, in welche während jeweiliger Kalibrierzeiträume ein Kalibrierstrom eingeleitet wird und eine Kompensation von Messfehlern erfolgt

In der DE 2015 217862 A2 ist ein Verfahren zum Kalibrieren eines Stromsensors gezeigt, wobei der Stromsensor eingerichtet ist, in einem Bordnetz eines Fahrzeuges einen durch einen Messwiderstand fließenden elektrischen Betriebsstrom basierend auf einer Gegenüberstellung eines durch den Betriebsstrom hervorgerufenen Spannungsabfall am Messwiderstand und einer vom Messwiderstand abhängigen Vorschrift zu bestimmen.

Die DE 10 2004 062655 A1 zeigt ein Korrekturverfahren, das eine Korrektur bezüglich der sich durch die durch den Stromfluss im Shuntwiderstand erzeugte Verlustleistung einstellenden Erhöhung der Temperatur des Shuntwiderstandes beinhaltet, für welche Eigenerwärmungskorrektur die Stromfluss bedingte Eigenerwärmung des Shuntwiderstandes durch Faltung einer aus der gemessenen Spannung ermittelten Verlustleistung als Eingangsgröße mit der Impulsantwort des Shuntwiderstandssystems simuliert wird.

Weitere Schaltungen zur Überwachung und zur Verbesserungen der Messung sind in der DE 10 2010 001529 A1, der US 2018149705 A1, der WO 2012/098968 A1, der CN 106 249 186 A, der CN 108 287 310 A, der JP 2001 110459 A, der DE 10 2017 203 535 A1, der WO 2018 162 021 A1 und der US 2006117197 A1 gezeigt.

Aufgabe der Erfindung ist es, ein Verfahren zum Betrieb eines Batteriesensors sowie einen Batteriesensor bereitzustellen, die eine bessere Abschätzung von alterungsbedingten Veränderungen ermöglicht.

Die Erfindung ist somit durch das Verfahren gemäß Anspruch 1 sowie durch den Batteriesensor gemäß Anspruch 14 definiert.

Zur Lösung der Aufgabe ist ein Verfahren zum Betrieb eines Batteriesensors vorgesehen, mit zumindest einer Erfassungseinrichtung zur Erfassung zumindest eines Batterieparameters und zur Ausgabe eines vom Batterieparameter abhängigen Batteriewertes, mit einer Auswerteschaltung zur Ermittlung eines korrigiertes Batteriewertes aus dem Batteriewert und einem Korrekturwert, und mit einer Korrekturwertermittlungseinrichtung, die zur Bestimmung des Korrekturwertes (84) in der Auswerteschaltung vorgesehen ist. Die Korrekturwertermittlungseinrichtung erfasst zumindest eine Einflusswert eines Einflussparameters, der den Korrekturwert (84) beeinflusst, wobei in der Korrekturwertermittlungseinrichtung für zumindest zwei Wertebereiche des Einflussparameters jeweils eine vorab ermittelte Zuordnungsvorschrift eines Korrekturfaktors zum jeweiligen Einflussparameter gespeichert ist. Das Verfahren weist die folgenden Schritte auf:
a) Erfassen zumindest eines Einflusswertes des zumindest einen Einflussparameters,
b) Ermittlung und Ausgabe des Wertebereichs des Einflussparameters für die erfassten Einflusswerte,
c) Auswahl der zumindest einem zum Wertebereich korrespondierenden Zuordnungsvorschrift,
d) Bestimmung und Ausgabe des zum Wertebereich des Einflussparameters korrespondierenden Korrekturfaktors aus der Zuordnungsvorschrift, und
e) Bestimmung des Korrekturwertes mit dem Korrekturfaktor. Der Erfindung liegt die Überlegung zugrunde, die Komponenten des Batteriesensors ohne eine künstliche Voralterung einzubauen. Hierbei ist es allerdings erforderlich, die Alterung der Komponenten des Batteriesensors möglichst genau abschätzen zu können, um einen vom jeweiligen Einflussfaktor abhängigen Korrekturfaktor bestimmen zu können, aus dem ein Korrekturwert für den gemessenen Batteriewert ermitteln zu können.

Hierzu wird vorab die Abhängigkeit der Komponenten des Batteriesensors von dem zumindest einen Einflussparameter ermittelt und hieraus ein Korrekturfaktor bzw. ein Korrekturwert für den gemessenen Batteriewert ermittelt. Dieser Zuordnungsvorschrift des Korrekturfaktors bzw. des Korrekturwertes zum Einflussparameters wird für verschiedene Einflusswerte des Einflussparameters bestimmt und in einer Korrekturwertermittlungseinrichtung gespeichert. Im Betrieb des Batteriesensors wird neben dem Batterieparameter der Einflussparameter bestimmt und jeweils der zu dem gemessenen Einflusswert des Einflussparameters korrespondierende Korrekturfaktor ausgewählt.

Anschließend wird mit diesem Korrekturfaktor ein Korrekturwert bestimmt, um den der gemessene Batteriewert korrigiert wird.

Dieses Verfahren wird im Betrieb des Batteriesensors wiederholt, um die Korrekturfaktoren sowie den Korrekturwert an die jeweils auf die Komponenten des Batteriesensors, insbesondere auf die Erfassungseinrichtung, einwirkenden Einflussparameter anzupassen. Dies ist insbesondere erforderlich, da sich eine Änderung des Einflusswertes eines Einflussparameters auf die Alterung der Komponenten des Batteriesensors auswirkt. Beispielsweise führt eine hohe Temperatur zu einer schnelleren Alterung.

Das Verfahren kann beispielsweise regelmäßig wiederholt werden, um eine regelmäßige Anpassung der Korrekturfaktoren sowie des Korrekturwertes zu erhalten. Das Verfahren kann ergänzend aber auch durchgeführt werden, wenn ein Einflusswert einen Grenzwert überschreitet oder ein außergewöhnlich hoher Einflusswert erfasst wird. Der Grenzwert kann beispielsweise ein einzelner Wert oder ein Zeitraum, über den der einzelne Wert anliegt, sein.

Insbesondere kann jeweils auch die Zeit erfasst werden, über die der Einflusswert anliegt und diese Zeit bei der Ermittlung des Korrekturfaktors bzw. des Korrekturwertes berücksichtigt werden.

Es erfolgt also keine direkte Messung der Abweichung der Messgenauigkeit der Erfassungseinrichtung, sondern es erfolgt eine Erfassung der Einflussparameter, die eine Auswirkung auf die Messgenauigkeit der Erfassungseinrichtung haben. Aus der Erfassung der Einflussparameter sowie dem vorab ermittelten Verhalten der Erfassungseinrichtungen bei Vorliegen des Einflussparameters wird die Abweichung der Messgenauigkeit geschätzt.

Dadurch, dass eine Voralterung der Komponenten des Batteriesensors nicht mehr erforderlich ist, können die Herstellungskosten für den Batteriesensor deutlich reduziert werden. Des Weiteren erfolgt auch bei einer Voralterung der Komponenten im Betrieb des Batteriesensors weiterhin eine Alterungsdrift, die mit dem vorstehend beschriebenen Verfahren ermittelt werden kann. Insgesamt kann somit die Messgenauigkeit des Batteriesensors deutlich besser werden, da alterungsbedingte Veränderungen der Messgenauigkeit sehr genau bestimmt werden können.

Die kann einen ersten Einflussfaktor aufweisen, der zeitunabhängig ist. Mit diesem ersten Einflussfaktor wird beispielsweise eine lediglich vom Einflussparameters abhängige Alterungsdrift angenommen. Das heißt, es wird angenommen, dass für einen Einflusswert eines Einflussparameters über die Betriebsdauer des Batteriesensors, also über die Lebensdauer des Batteriesensors, eine gleichmäßige Veränderungen der Messgenauigkeit erfolgt.

Die vorab ermittelte Zuordnungsvorschrift eines Korrekturfaktors zum jeweiligen Einflussparameter kann auch einen zweiten Einflussfaktor aufweisen, der abhängig von der Gesamtbetriebsdauer des Batteriesensors ist, wobei zusätzlich die Gesamtbetriebsdauer des Batteriesensors erfasst wird und der zweite Einflussfaktor in Abhängigkeit von der Gesamtbetriebsdauer und dem Wertebereich des Einflussparameters bestimmt wird. Die Alterungsdrift einer Eigenschaft der Erfassungseinrichtungen kann sich einem Grenzwert annähern. Das heißt, zu Beginn weist die Erfassungseinrichtungen eine hohe Veränderung der Messeigenschaften auf, die mit zunehmender Betriebsdauer des Batteriesensors kleiner wird. Um dieser Eigenschaft Rechnung zu tragen, wird ein zeitabhängiger zweiter Einflussfaktor und dessen zeitlicher Verlauf ermittelt und gespeichert. Im Betrieb des Batteriesensors wird zusätzlich zum Einflussparameters auch die Betriebsdauer des Batteriesensors erfasst, sodass der Einflussfaktor nicht nur in Abhängigkeit von dem ermittelten Einfluss Wert des Einflussparameters bestimmt wird, sondern auch in Abhängigkeit von der Betriebsdauer des Batteriesensors. Die erfasste Zeit des Batteriesensors kann zusätzlich in die Ermittlung des Korrekturwertes aus dem Korrekturfaktor eingehen.

Beispielsweise werden sowohl ein erster Einflussfaktor wie auch ein zweiter Einflussfaktor ermittelt und ein erster, zeitlich unabhängiger Einflussfaktor wird mit dem zweiten Einflussfaktor in Abhängigkeit von der ermittelten Gesamtbetriebsdauer korrigiert.

Die vorab ermittelte Zuordnungsvorschrift eines Korrekturfaktors zum jeweiligen Einflussparameter kann beispielsweise zumindest zwei Kennlinien, insbesondere ein Kennlinienfeld, umfassen. Für verschiedene Einflusswerte des Einflussparameters ist also jeweils eine Kennlinie gespeichert.

Eine Alterung des Batteriesensors kann durch verschiedene, auf den Batteriesensor einwirkende Einflüsse erfolgen. Beispielsweise erfolgt eine Alterung auch durch den regulären Betrieb des Batteriesensors, also durch die Batterieparameter, die von der Erfassungseinrichtung erfasst werden. Zumindest ein Einflussparameter kann daher ein Batterieparameter sein, insbesondere ein Batteriestrom, eine Batteriespannung und/oder eine Batterietemperatur.

Darüber hinaus wirken auf den Batteriesensor auf weitere Einflüsse, die eine Veränderung des Messbereichs oder der Messgenauigkeit des Batteriesensors bewirken. Zumindest ein Einflussparameter kann daher unabhängig von der Batterie sein, insbesondere eine mechanische Belastung, sein. Solche äußeren Einflussparameter können beispielsweise Witterungseinflüsse wie Außentemperatur, Salznebel, Korrosion oder auch mechanische Belastungen wie Vibrationen, sein.

Ist der Einflussparameter ein Batterieparameter, kann der Einflussparameters mit einer Erfassungseinrichtung zur Erfassung eines Batterieparameters erfasst werden, so dass keine zusätzlichen Erfassungseinrichtungen, insbesondere keine zusätzlichen Sensoren, erforderlich sind.

Ist der Einflussparameter ein äußerer Einfluss auf Batteriesensor, wird der Einflussparameter mit einer Einflussparametererfassungseinrichtung zur Erfassung zumindest eines Einflussparameters und zur Ausgabe zumindest eines Einflusswertes an die Korrekturwertermittlungseinrichtung erfasst. Es ist also ein zusätzlicher Sensor vorgesehen, der den Einflussparameters erfasst und einen Einflusswert ausgibt.

Um die Genauigkeit des Verfahrens zu verbessern, können auch mehrere Einflussparameter erfasst werden, wobei in der Korrekturwertermittlungseinrichtung für mehrere Einflussparameter jeweils zumindest eine vorab ermittelte Zuordnungsvorschrift eines Korrekturfaktors zum jeweiligen Einflussparameter gespeichert ist, wobei für jeden Einflussparameter ein Korrekturfaktor ermittelt wird.

Der Korrekturwert kann beispielsweise mit den einzelnen Korrekturfaktoren korrigiert werden. Es ist aber auch möglich, aus den ermittelten Korrekturfaktoren einen Gesamtkorrekturfaktor zu ermitteln, mit dem der Korrekturwert bestimmt wird.

In der Korrekturwertermittlungseinrichtung kann ein Startkorrekturwert gespeichert sein, der mit dem ermittelten Korrekturfaktor korrigiert wird. Der aus dem Startkorrekturwert und dem Korrekturfaktor ermittelte neue Korrekturwert kann als neuer Startkorrekturwert gespeichert werden und bei einer Wiederholung des Verfahrens erneut mit dem ermittelten Korrekturfaktor korrigiert werden. Es erfolgt also eine permanente Anpassung des Korrekturwertes.

Optional kann das Verfahren weitere Schritte aufweisen, beispielsweise zur Selbstüberwachung oder zur Kalibrierung des Batteriesensors. Beispielsweise kann ein Batterieparameter mit bekannter Größe an den Batteriesensor angelegt werden und geprüft werden, ob der mit dem Korrekturwert korrigierte Batteriewert mit dem angelegten Wert des Batterieparameters übereinstimmt.

Beispielsweise kann der Batteriesensor eine Stromerfassungseinrichtung aufweisen, die einen Messwiderstand sowie eine Spannungserfassungseinrichtung zur Erfassung eines Spannungsabfalls über den Messwiderstand aufweisen. Der über den Messwiderstand fließende Strom wird aus dem erfassten Spannungsabfall über den Messwiderstand sowie den bekannten elektrischen Widerstand des Messwiderstandes bestimmt. Der elektrische Messwiderstand kann sich aber abhängig von Einflussfaktoren ändern, wobei diese Änderung mit der Bestimmung des Korrekturwertes mit dem vorstehend beschriebenen Verfahren korrigiert wird.

Zusätzlich kann ein Referenzstrom mit bekannter Größe an den Messwiderstand angelegt werden und der Spannungsabfall dieses Referenzstroms über den Messwiderstand mit der Spannungserfassungseinrichtung erfasst werden. Aus dem Spannungsabfall und dem bekannten Referenzstrom kann über das ohmsche Gesetz der elektrische Widerstand des Messwiderstandes ermittelt werden. Bei einer anschließenden Laststrommessung kann der mit dem berechneten elektrischen Widerstand ermittelte Laststrom mit dem Laststrom, der mit dem Korrekturwert ermittelt wird, verglichen werden und somit der Korrekturwert gegebenenfalls angepasst werden.

Zur Lösung der Aufgabe ist des Weiteren ein Batteriesensor vorgesehen, mit zumindest einer Erfassungseinrichtung, die zur Erfassung zumindest eines Batterieparameters und zur Ausgabe eines vom Batterieparameter abhängigen Batteriewertes eingerichtet ist. Der Batteriesensor weist des Weiteren eine Auswerteschaltung auf, die zur Ermittlung eines korrigiertes Batteriewertes aus dem Batteriewert und einem Korrekturwert eingerichtet ist sowie eine Korrekturwertermittlungseinrichtung, die zur Bestimmung des Korrekturwertes in der Auswerteschaltung vorgesehen ist. Die Korrekturwertermittlungseinrichtung ist dazu eingerichtet, zumindest einen Einflusswert eines Einflussparameters zu erfassen, der den Korrekturwert beeinflusst. Die Korrekturwertermittlungseinrichtung ist des Weiteren dazu eingerichtet, für zumindest zwei Wertebereiche des Einflussparameters jeweils eine vorab ermittelte Zuordnungsvorschrift eines Korrekturfaktors zu speichern und den Korrekturwert mit einem vorstehend beschriebenen Verfahren zu ermitteln. Der Batteriesensor ist somit zur Durchführung der folgenden Schritte ausgebildet:
a) Erfassen zumindest eines Einflusswertes des zumindest einen Einflussparameters,
b) Ermittlung und Ausgabe des Wertebereichs des Einflussparameters für die erfassten Einflusswerte,
c) Auswahl der zumindest einem zum Wertebereich korrespondierenden Zuordnungsvorschrift,
d) Bestimmung und Ausgabe des zum Wertebereich des Einflussparameters korrespondierenden Korrekturfaktors aus der Zuordnungsvorschrift, und
e) Bestimmung des Korrekturwertes mit dem Korrekturfaktor.

Weitere Vorteile Merkmale ergeben sich aus der nachfolgenden Beschreibung in Verbindung mit den beigefügten Zeichnungen in diesen zeigen:
- Figur 1: eine schematische Darstellung eines Fahrzeugs mit einem Stromkreis;
- Figur 2: eine schematische Darstellung eines Batteriesensors; und
- Figur 3: ein Ablaufdiagramm eines Verfahrens zur Bestimmung eines Korrekturwertes mit dem Batteriesensor aus Figur 2.

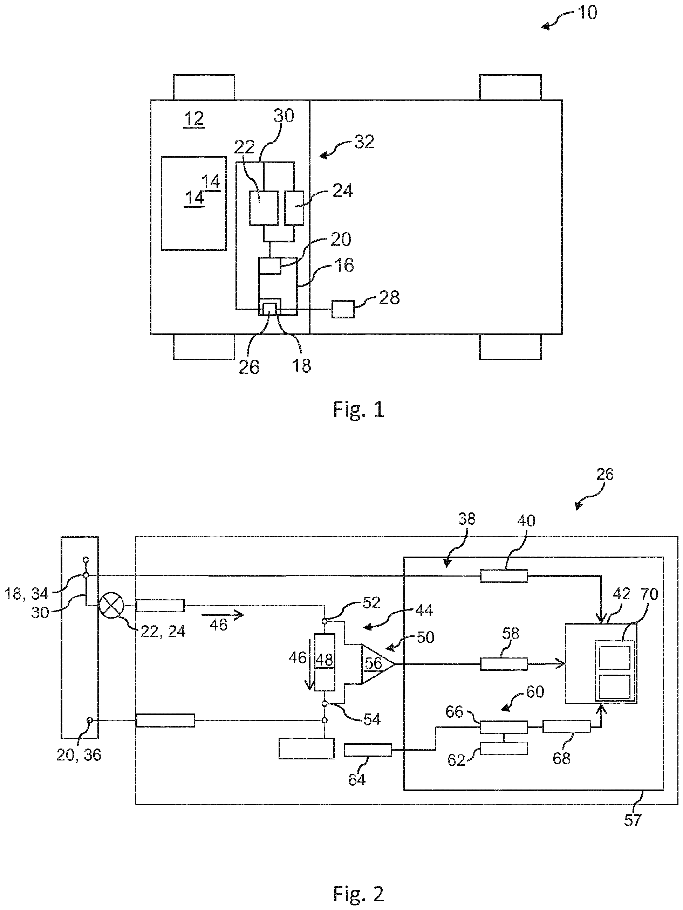

In Figur 1 ist ein Fahrzeug 10 gezeigt. Das Fahrzeug 10 hat einen Motorraum 12, in dem eine Antriebseinheit 14 vorgesehen ist. Des Weiteren ist eine Fahrzeugbatterie 16 mit zwei Batteriepolen 18, 20 vorgesehen, die mit mehreren elektrischen Verbrauchern 22, 24 elektrisch verbunden ist. Die elektrischen Verbraucher 22, 24 können beliebige elektrische oder elektronische Komponenten des Fahrzeugs 10 sein, beispielsweise eine Klimaanlage, Fahrassistenzsysteme oder auch Teile der Antriebseinheit 14. Insbesondere kann die Antriebseinheit 14 ebenfalls ein elektrischer Verbraucher sein, der mit der Fahrzeugbatterie 16 elektrisch verbunden ist.

An der Fahrzeugbatterie 16, insbesondere am Batteriepol 18 ist des Weiteren ein Batteriesensor 26 vorgesehen. Der Batteriesensor 26 erfasst zumindest einen, vorzugsweise mehrere Batteriewerte, um Aussagen über den Batteriezustand, insbesondere über den Ladezustand der Fahrzeugbatterie 16, treffen zu können. Der Batteriesensor 26 kann mit einer Steuereinheit 28 des Fahrzeugs verbunden sein, die die Signale des Batteriesensor 26 auswertet.

Der Batteriesensor 26, die Verbraucher 22, 24 sowie die Fahrzeugbatterie 16 sind untereinander über elektrische Verbindungen 30 verbunden und bilden zusammen mit diesen elektrischen Verbindungen 30 einen Stromkreis 32. die elektrischen Verbindungen 30 können beispielsweise durch Kabel oder Teile der Fahrzeugkarosserie gebildet sein.

In Figur 2 ist eine Ausführungsform eines Batteriesensors 26 gezeigt. An einem ersten Anschluss 34 des Batteriesensor 26 ist eine elektrische Verbindung 30 vorgesehen, die wie die Verbraucher 22, 24 mit einem Batteriepol 18 der Fahrzeugbatterie 16 verbunden ist. Der zweite Anschluss 36 ist durch eine Polklemme gebildet, über die der Batteriesensor 26 mit dem zweiten Batteriepol 20 elektrisch verbunden ist.

Der hier dargestellte Batteriesensor 26 ist dazu ausgebildet, als Batterieparameter die Batteriespannung, den Batteriestrom sowie die Batterietemperatur zu erfassen.

Zur Messung der Batteriespannung ist eine Spannungserfassungseinrichtung 38 vorgesehen, die mit dem ersten Anschluss 30 bzw. dem ersten Batteriepol 18 verbunden ist. Die Spannungserfassungseinrichtung 38 ist über einen Analog-Digital-Wandler mit einer Auswerteschaltung 42 des Batteriesensors 26 verbunden.

Des Weiteren ist eine Stromerfassungseinrichtung 44 zur Erfassung des Laststroms 46 zwischen dem ersten Batteriepole 18 und dem zweiten Batteriepol 20 vorgesehen. Die Stromerfassungseinrichtung hat einen im Pfad des Laststroms 46 angeordneten Messwiderstand 48 mit einem bekannten elektrischen Widerstand. Vorzugsweise ist der Messwiderstand 48 aus einem Material hergestellt, dass eine geringe Temperaturabhängigkeit sowie eine geringe Alterungsdrift des elektrischen Widerstandes aufweist, beispielsweise aus einer Kupfer-Nickel-Mangan-Legierung.

Die Stromerfassungseinrichtung 44 weist des Weiteren eine Spannungsmesseinrichtung 50 auf, die mit Kontaktstellen 52, 54 vor und nach dem Messwiderstand 48 kontaktiert ist, sodass diese eine Spannungsabfall des Laststroms 46 über den Messwiderstand 48 erfassen kann. Die Stromerfassungseinrichtung 44 weist des Weiteren einen Verstärker 56 sowie einen Analog-Digital-Wandler 58 auf, der mit der Auswerteschaltung 42 verbunden ist.

Aus dem mit der Spannungsmesseinrichtung 50 erfassten Spannungsabfall über den Messwiderstand 48 und dem bekannten elektrischen Widerstand des Messwiderstandes 48 kann über das ohmsche Gesetz der über den Messwiderstand 48 fließende Strom, also der Laststroms 46, ermittelt werden. Der mit dem der Stromerfassungseinrichtung 44 ermittelte Wert des Laststroms 46 wird an die Auswerteschaltung 42 ausgegeben.

Die Batterietemperatur wird mit einer Temperaturerfassungseinrichtung 60 erfasst, die einen ersten Temperatursensor 62 und/oder einen zweiten Temperatursensor 64 aufweist. Der erste Temperatursensor 62 ist auf einer Leiterplatte 57 angeordnet, auf der auch die Auswerteschaltung 42 sowie die Analog-Digital-Wandler 40 und 58 vorgesehen sind. Der zweite Temperatursensor 64 kann beispielsweise am Messwiderstand 48 oder der Fahrzeugbatterie 16 vorgesehen sein. Über einen Umschalter 66 ist wahlweise der erste Temperatursensor 62 oder der zweite Temperatursensor 64 mit einem Analog-Digital-Wandler 68 verbindbar, der mit der Auswerteschaltung 42 verbunden ist.

Die Messungenauigkeiten und/oder die Messbereiche der Erfassungseinrichtungen 38, 44, 60 können sich über die Lebensdauer und/oder aufgrund von Einflüssen, die auf die Erfassungseinrichtungen 38, 44, 60 wirken, verändern und/oder verschieben. Aus diesem Grund werden die erfassten Batteriewerte der Batterieparameter, also Batteriespannung, der Batteriestrom und/oder die Batterietemperatur in der Auswerteschaltung 42 mit einem Korrekturwert korrigiert.

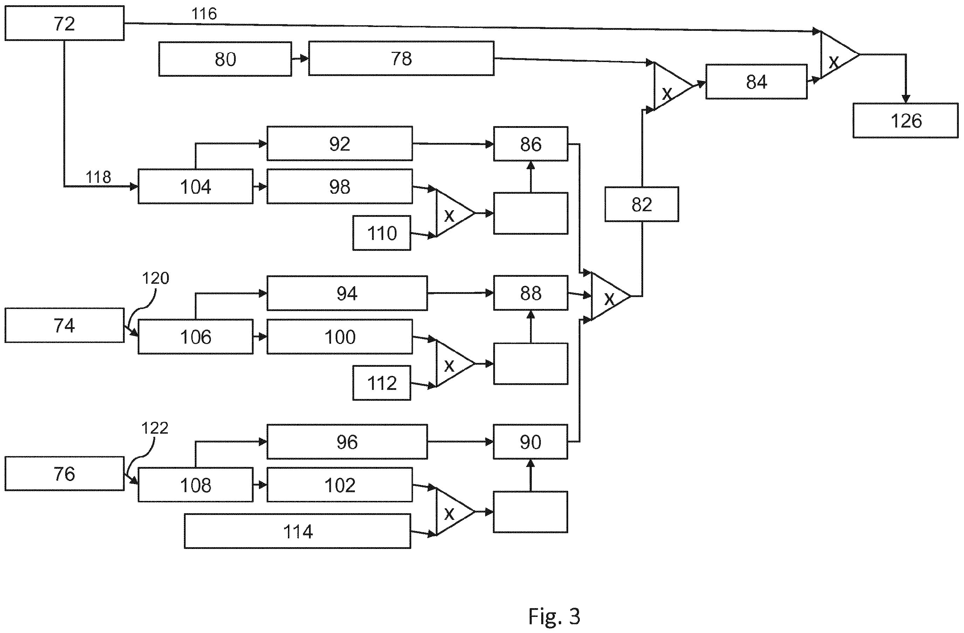

Zur Bestimmung des Korrekturwertes für einen Batterieparameter ist in der Auswerteschaltung 42 eine Korrekturwertermittlungseinrichtung 70 vorgesehen. Die Korrekturwertermittlungseinrichtung weist zumindest einen Eingang für einen Einflusswert eines Einflussparameters der den Korrekturwert beeinflusst, auf. In dem nachfolgend in Figur 3 beschriebenen Ausführungsbeispiel sind drei Einflussparameter vorgesehen, wobei der erste Einflussparameter 72 der mit der Stromerfassungseinrichtung ermittelte Batteriestrom ist und ein zweiter Einflussparameter 74 die mit der Temperaturerfassungseinrichtungen 60 erfasste Batterietemperatur. Ein dritter Einflussparameter 76 kann beispielsweise eine mechanische Belastung sein, die auf den Batteriesensor 26 wirkt.

Wie in Figur 3 zu sehen ist, ist in der Korrekturwertermittlungseinrichtung 70 ein Startkorrekturwert 78 gespeichert, der mit einem Kalibrierungsverfahren 80 ermittelt wurde. In dem nachfolgend beschriebenen Verfahren wird die Ermittlung eines Korrekturfaktors 82 beschrieben, mit dem aus dem Startkorrekturwert 78 der Korrekturwert 84 ermittelt wird, um den der Batterieparameter korrigiert wird.

Für jeden der Einflussparameter 72, 74, 76 wurde vorab für zumindest zwei Wertebereiche des Einflussparameters ein Zusammenhang zwischen dem Einflussparameter und dem Korrekturwert ermittelt, beispielsweise durch Versuche. Aus diesem Zusammenhang wurden für die verschiedenen Wertebereiche des Einflussparameters 72, 74, 76 jeweils eine Zuordnungsvorschrift eines Korrekturfaktors 86, 88, 90 zum jeweiligen Einflussparameter 72, 74, 76 ermittelt, der in der Korrekturwertermittlungseinrichtung 70 gespeichert ist.

In der in Figur 3 beschriebenen Ausführungsform des Verfahrens sind für jeden Einflussparameter 72, 74, 76 ein zeitunabhängiger erster Einflussfaktor 92, 94, 96 gespeichert, der zu einem experimentell ermittelten Endwert des Korrekturwertes 84 korrespondiert bzw. diesem entspricht.

Des Weiteren ist jeweils ein zweiter, zeitabhängiger Einflussfaktor 98, 100, 102 gespeichert. Die Alterung der Erfassungseinrichtungen ist üblicherweise zu Beginn der Betriebsdauer sehr hoch und nähert sich mit Betriebsdauer des Batteriesensors 26 einem Grenzwert (92, 94, 96). Diesen Umstand wird mit dem zweiten, zeitabhängigen Einflussfaktor 98, 100, 102 berücksichtigt.

Beispielsweise kann die Zuordnungsvorschrift eines Korrekturfaktors 86, 88, 90 zum jeweiligen Einflussparameter 72, 74, 76 auch in Form eines Kennlinienfeldes 104, 106, 108 abgespeichert sein, wobei für verschiedenen Wertebereiche des Batterieparameters 72, 74, 76 jeweils eine Kennlinie vorab ermittelt und gespeichert wurde.

Zusätzlich wird für den zweiten Einflussfaktor 98, 100, 102 mit einer Messeinrichtung 110, 112 die Betriebsdauer bzw. mit einer Messeinrichtung 114 die Zeit, in der der Einflussparameter angelegt und/oder die Anzahl der Ereignisse des Batterieparameters 76 gemessen.

Zur Bestimmung des Batteriewertes 126 wird zunächst der Batterieparameter, also in der hier gezeigten Ausführungsform der Batteriestrom, erfasst und ein Batteriewert 116 an die Auswerteschaltung 42 ausgegeben.

Des Weiteren werden die Einflussparameter erfasst und die Einflusswerte 118, 120, 122 an die Korrekturwertermittlungseinrichtung 70 ausgegeben. In der Korrekturwertermittlungseinrichtung 70 werden für die erfassten Einflusswerte 118, 120, 122 die Wertebereiche und somit die zu den Wertebereichen korrespondierenden Korrekturfaktoren 86, 88, 90 ermittelt und ausgegeben. Anschließend wird aus den Korrekturfaktoren 86, 88, 90 ein Gesamtkorrekturfaktor 82 ermittelt, mit dem der Startkorrekturwert 78 korrigiert wird.

Anschließend wird der gemessene Batteriewert 116 mit diesem korrigierten Korrekturwert 84 korrigiert und als korrigierter Batteriewert 126 ausgegeben.

Dieses Verfahren wird wiederholt durchgeführt, beispielsweise regelmäßig oder bei Erkennung bestimmter Ereignisse, die einen Einfluss auf die Alterung des Batteriesensors 26 haben. Hierbei wird der ermittelte bzw. korrigierte Korrekturwert 84 als neuer Startkorrekturwert 78 abgespeichert und mit dem nachfolgend ermittelten Gesamtkorrekturfaktor 82 korrigiert.

Wie in Figur 3 zu sehen ist, wird die Bestimmung der Korrekturfaktoren 86, 88, 90 jeweils aus dem Kennlinienfeld 104, 106, 108 dem ersten Einflussfaktor 92, 94, 96 sowie dem zweiten Einflussfaktor 98, 100, 102 ermittelt. Der zweite Einflussfaktor 96, 100, 102 wird unter Berücksichtigung der mit der Messeinrichtung 110, 112,114 ermittelten Betriebsdauer bzw. der Dauer oder der Anzahl der Ereignisse korrigiert und anschließend gegebenenfalls verstärkt. Nachfolgend wird der erste Einflussfaktor 92, 94, 96 jeweils mit dem zweiten Einflussfaktor 98, 100, 102 korrigiert.

Mit dem vorstehend beschriebenen Verfahren erfolgt also keine direkte Messung bzw. Erfassung einer Veränderung oder Verschiebung eines Messbereichs oder einer Messgenauigkeit des Batteriesensors 26. Vielmehr werden die Einflussparameter 72, 74, 76, die einen Einfluss auf eine Veränderung oder Verschiebung eines Messbereichs oder einer Messgenauigkeit des Batteriesensor 26 haben, ermittelt und die Veränderung der Verschiebung des Messbereichs oder der Messgenauigkeit anhand der auf den Batteriesensor 26 wirkenden Einflussparameter 72, 74, 76 bestimmt. Hierzu werden insbesondere für jeden Einflussparameter 72, 74, 76 Wertebereiche definiert, wobei für jeden Wertebereich vorab eine Zuordnungsvorschrift eines Korrekturfaktors 86, 88, 90 zum jeweiligen Einflussparameter 72, 74, 76 ermittelt wurde. Da das Alterungsverhalten in Abhängigkeit von den wirkenden Einflussparameter 72, 74, 76 bestimmt wird, ist somit keine Voralterung der Komponenten des Batteriesensors 26 erforderlich.

Um die Genauigkeit der Bestimmung des Korrekturfaktors 82 bzw. des Korrekturwertes 84 zu prüfen, kann der Batteriesensor zusätzliche Kalibrierverfahren oder Prüfverfahren aufweisen.

Beispielsweise kann eine Referenzstromschaltung vorgesehen sein, mit der ein Referenzstrom mit bekannter Größe an den Messwiderstand 48 angelegt werden kann. Der mit der Stromerfassungseinrichtung erfasste und mit dem ermittelten Korrekturwert korrigierte Batteriestrom in kann mit dem Referenzstrom verglichen werden. Bei einer Abweichung des korrigierten Batteriestroms und des Referenzstroms kann beispielsweise der Startkorrekturwert 78 angepasst werden.

Darüber hinaus können weitere Prüf- oder Kalibrierverfahren vorgesehen sein, die eine Prüfung oder eine Anpassung des Korrekturfaktors 118 und/oder des Korrekturwertes 84 ermöglichen

## Patentansprüche

1. Verfahren zum Betrieb eines Batteriesensors (26), mit zumindest einer Erfassungseinrichtung (38, 44, 60) zur Erfassung zumindest eines Batterieparameters und zur Ausgabe eines vom Batterieparameter abhängigen Batteriewertes (116), mit einer Auswerteschaltung (42) zur Ermittlung eines korrigiertes Batteriewertes (126) aus dem Batteriewert (116) und einem Korrekturwert (84), und mit einer Korrekturwertermittlungseinrichtung (70), die zur Bestimmung des Korrekturwertes (84) in der Auswerteschaltung vorgesehen ist,
**dadurch gekennzeichnet, dass**
die Korrekturwertermittlungseinrichtung zumindest einen Einflusswert eines Einflussparameters des Korrekturwertes erfasst, der den Korrekturwert (84) beeinflusst, wobei in der Korrekturwertermittlungseinrichtung (70) für zumindest zwei Wertebereiche des Einflussparameters jeweils eine vorab ermittelte Zuordnungsvorschrift eines Korrekturfaktors (82, 86, 88, 90) zum jeweiligen Einflussparameter (72, 74, 76) gespeichert ist, wobei der Korrekturwert (84) mit folgenden Schritten ermittelt wird:
a) Erfassen zumindest eines Einflusswertes des zumindest einen Einflussparameters (72, 74, 76),
b) Ermittlung und Ausgabe des Wertebereichs des Einflussparameters (72, 74, 76) für die erfassten Einflusswerte (118, 120, 122),
c) Auswahl der zumindest einem zum Wertebereich korrespondierenden Zuordnungsvorschrift,
d) Bestimmung und Ausgabe des zum Wertebereich des Einflussparameters (72, 74, 76) korrespondierenden Korrekturfaktors (82, 86, 88, 90) aus der Zuordnungsvorschrift, und
e) Bestimmung des Korrekturwertes (84) mit dem Korrekturfaktor (82, 86, 88, 90).

2. Verfahren nach Anspruch 1, **dadurch gekennzeichnet, dass** die Schritte a) bis e) wiederholt durchgeführt werden.

3. Verfahren nach einem der Ansprüche 1 und 2, **dadurch gekennzeichnet, dass** die vorab ermittelte Zuordnungsvorschrift des Korrekturfaktors (86, 88, 90) und des Einflussparameters (72, 74, 76) einen ersten Einflussfaktor (92, 94, 96) aufweist, der zeitunabhängig ist, abbildet.

4. Verfahren nach einem der vorhergehenden Ansprüche, **dadurch gekennzeichnet, dass** die vorab ermittelte Zuordnungsvorschrift des Korrekturfaktors (86, 88, 90) und des Einflussparameters (72, 74, 76) einen zweiten Einflussfaktor (98, 100, 102) aufweist, der abhängig von einer Zeit ist, insbesondere der Gesamtbetriebsdauer des Batteriesensors (26), wobei zusätzlich die Zeit, insbesondere die Gesamtbetriebsdauer des Batteriesensors (26) erfasst wird und der zweite Einflussfaktor (98, 100, 102) in Abhängigkeit von der Zeit, insbesondere der Gesamtbetriebsdauer, und dem Wertebereich des Einflussparameters (72, 74, 76) bestimmt wird.

5. Verfahren nach Anspruch 4, **dadurch gekennzeichnet, dass** ein erster, zeitlich unabhängiger Einflussfaktor (92, 94, 96) mit dem zweiten Einflussfaktor (98, 100, 102) in Abhängigkeit von der ermittelten Zeit, insbesondere der Gesamtbetriebsdauer, korrigiert wird.

6. Verfahren nach einem der vorhergehenden Ansprüche, **dadurch gekennzeichnet, dass** die vorab ermittelten Zuordnungsvorschriften des Korrekturfaktors (86, 88, 90) und des Einflussparameters (72, 74, 76) zumindest zwei Kennlinien, insbesondere ein Kennlinienfeld (104, 106, 108), umfasst.

7. Verfahren nach einem der vorhergehenden Ansprüche, **dadurch gekennzeichnet, dass** zumindest ein Einflussparameter (72, 74, 76) ein Batterieparameter, insbesondere ein Batteriestrom, eine Batteriespannung und/oder eine Batterietemperatur, ist.

8. Verfahren nach einem der vorhergehenden Ansprüche, **dadurch gekennzeichnet, dass** zumindest ein Einflussparameter (72, 74, 76) unabhängig von der Batterie ist, insbesondere eine mechanische Belastung, ist.

9. Verfahren nach einem der vorhergehenden Ansprüche, **dadurch gekennzeichnet, dass** der Einflussparameter (72, 74, 76) mit einer Erfassungseinrichtung (36, 44, 60) zur Erfassung eines Batterieparameters erfasst wird.

10. Verfahren nach einem der vorhergehenden Ansprüche, **dadurch gekennzeichnet, dass** der Einflussparameter (72, 74, 76) mit einer Einflussparametererfassungseinrichtung zur Erfassung zumindest eines Einflussparameters (72, 74, 76) und zur Ausgabe zumindest eines Einflusswertes an die Korrekturwertermittlungseinrichtung (70) erfasst wird.

11. Verfahren nach einem der vorhergehenden Ansprüche, **dadurch gekennzeichnet, dass** in der Korrekturwertermittlungseinrichtung (70) für mehrere Einflussparameter (72, 74, 76) jeweils zumindest eine die vorab ermittelte Zuordnungsvorschrift des Korrekturfaktors (86, 88, 90) und des Einflussparameters (72, 74, 76) gespeichert ist, wobei für jeden Einflussparameter (72, 74, 76) ein Korrekturfaktor (86, 88, 90) ermittelt wird.

12. Verfahren nach Anspruch 11, **dadurch gekennzeichnet, dass** aus den ermittelten Korrekturfaktoren (86, 88, 90) ein Gesamtkorrekturfaktor (82) ermittelt wird, mit dem der Korrekturwert (84) bestimmt wird.

13. Verfahren nach einem der vorhergehenden Ansprüche, **dadurch gekennzeichnet, dass** in der Korrekturwertermittlungseinrichtung (70) ein Startkorrekturwert (78) gespeichert ist, der mit dem ermittelten Korrekturfaktor (82, 86, 88, 90) korrigiert wird.

14. Batteriesensor (26), mit zumindest einer Erfassungseinrichtung (38, 44, 60) eingerichtet zur Erfassung zumindest eines Batterieparameters und zur Ausgabe eines vom Batterieparameter abhängigen Batteriewertes (116), mit einer Auswerteschaltung (42) eingerichtet zur Ermittlung eines korrigiertes Batteriewertes (126) aus dem Batteriewert (116) und einem Korrekturwert (84), und mit einer Korrekturwertermittlungseinrichtung (70), die zur Bestimmung des Korrekturwertes (84) in der Auswerteschaltung vorgesehen ist,
**dadurch gekennzeichnet, dass**
die Korrekturwertermittlungseinrichtung (70) dazu eingerichtet ist, zumindest einen Einflusswert eines Einflussparameters zu erfassen, der den Korrekturwert (84) beeinflusst, wobei die Korrekturwertermittlungseinrichtung (70) dazu eingerichtet ist, für zumindest zwei Wertebereiche des Einflussparameters jeweils eine vorab ermittelte Zuordnungsvorschrift eines Korrekturfaktors (82, 86, 88, 90) zu speichern, und wobei die Korrekturwertermittlungseinrichtung (70) dazu eingerichtet ist, den Korrekturwert (84) mit folgenden Schritten zu ermitteln:
a) Erfassen zumindest eines Einflusswertes des zumindest einen Einflussparameters (72, 74, 76),
b) Ermittlung und Ausgabe des Wertebereichs des Einflussparameters (72, 74, 76) für die erfassten Einflusswerte (118, 120, 122),
c) Auswahl der zumindest einem zum Wertebereich korrespondierenden Zuordnungsvorschrift,
d) Bestimmung und Ausgabe des zum Wertebereich des Einflussparameters (72, 74, 76) korrespondierenden Korrekturfaktors (82, 86, 88, 90) aus der Zuordnungsvorschrift, und
e) Bestimmung des Korrekturwertes (84) mit dem Korrekturfaktor (82, 86, 88, 90).

## Claims

1. Method for operating a battery sensor (26), having at least one capture device (38, 44, 60) for capturing at least one battery parameter and outputting a battery value (116) dependent on the battery parameter, having an evaluation circuit (42) for determining a corrected battery value (126) from the battery value (116) and from a correction value (84), and having a correction value determination device (70) which is provided for the purpose of determining the correction value (84) in the evaluation circuit,
**characterized in that**
the correction value determination device (70) captures at least one influencing value of an influencing parameter of the correction value that influences the correction value (84), wherein a pre-determined rule for assigning a correction factor (82, 86, 88, 90) to the respective influencing parameter (72, 74, 76) is respectively stored in the correction value determination device (70) for at least two value ranges of the influencing parameter, the correction value (84) being determined with the following steps:
a) capturing at least one influencing value of the at least one influencing parameter (72, 74, 76),
b) determining and outputting the value range of the influencing parameter (72, 74, 76) for the captured influencing values (118, 120, 122),
c) selecting the at least one assignment rule corresponding to the value range,
d) determining and outputting the correction factor (82, 86, 88, 90) corresponding to the value range of the influencing parameter (72, 74, 76) from the assignment rule, and
e) determining the correction value (84) with the correction factor (82, 86, 88, 90).

2. Method according to Claim 1, **characterized in that** steps a) to e) are carried out repeatedly.

3. Method according to either of Claims 1 and 2, **characterized in that** the pre-determined rule for assigning the correction factor (86, 88, 90) and the influencing parameter (72, 74, 76) comprises a first influencing factor (92, 94, 96) which is time-independent.

4. Method according to one of the preceding claims, **characterized in that** the pre-determined rule for assigning the correction factor (86, 88, 90) and the influencing parameter (72, 74, 76) comprises a second influencing factor (98, 100, 102) which is dependent on a time, in particular the total operating time of the battery sensor (26), wherein the time, in particular the total operating time of the battery sensor (26), is additionally detected and the second influencing factor (98, 100, 102) is determined as a function of the time, in particular the total operating time, and the value range of the influencing parameter (72, 74, 76).

5. Method according to Claim 4, **characterized in that** a first, time-independent influencing factor (92, 94, 96) is corrected with the second influencing factor (98, 100, 102) as a function of the determined time, in particular the total operating time.

6. Method according to one of the preceding claims, **characterized in that** the pre-determined rule for assigning the correction factor (86, 88, 90) and the influencing parameter (72, 74, 76) comprises at least two characteristics, in particular a characteristic map (104, 106, 108).

7. Method according to one of the preceding claims, **characterized in that** at least one influencing parameter (72, 74, 76) is a battery parameter, in particular a battery current, a battery voltage and/or a battery temperature.

8. Method according to one of the preceding claims, **characterized in that** at least one influencing parameter (72, 74, 76) is independent of the battery, in particular a mechanical stress.

9. Method according to one of the preceding claims, **characterized in that** the influencing parameter (72, 74, 76) is captured with a capture device (36, 44, 60) for capturing a battery parameter.

10. Method according to one of the preceding claims, **characterized in that** the influencing parameter (72, 74, 76) is captured with an influencing parameter capture device for capturing at least one influencing parameter (72, 74, 76) and for outputting at least one influencing value to the correction value determination device (70).

11. Method according to one of the preceding claims, **characterized in that** at least one pre-determined rule for assigning the correction factor (82, 86, 88, 90) and the influencing parameter (72, 74, 76) is respectively stored in the correction value determination device (70) for a plurality of influencing parameters (72, 74, 76), one correction factor (86, 88, 90) being determined for each influencing parameter (72, 74, 76).

12. Method according to Claim 11, **characterized in that** an overall correction factor (82) is determined from the determined correction factors (86, 88, 90) and is used to determine the correction value (84).

13. Method according to one of the preceding claims, **characterized in that** an initial correction value (78) which is corrected with the determined correction factor (82, 86, 88, 90) is stored in the correction value determination device (70).

14. Battery sensor (26), having at least one capture device (38, 44, 60) for capturing at least one battery parameter and outputting a battery value (116) dependent on the battery parameter, having an evaluation circuit (42) for determining a corrected battery value (126) from the battery value (116) and from a correction value (84), and having a correction value determination device (70) which is provided for the purpose of determining the correction value (84),
**characterized in that**
the correction value determination device (70) is configured to capture at least one influencing value of an influencing parameter that influences the correction value (84), wherein the correction value determination device (70) is configured to respectively store a pre-determined rule for assigning a correction factor (82, 86, 88, 90) for at least two value ranges of the influencing parameter, and wherein the correction value determination device (70) is configured to determine the correction value (84) with the following steps:
a) capturing at least one influencing value of the at least one influencing parameter (72, 74, 76),
b) determining and outputting the value range of the influencing parameter (72, 74, 76) for the captured influencing values (118, 120, 122),
c) selecting the at least one assignment rule corresponding to the value range,
d) determining and outputting the correction factor (82, 86, 88, 90) corresponding to the value range of the influencing parameter (72, 74, 76) from the assignment rule, and
e) determining the correction value (84) with the correction factor (82, 86, 88, 90).

## Revendications

1. Procédé permettant de faire fonctionner un capteur de batterie (26), comprenant au moins un dispositif de détection (38, 44, 60) servant à détecter au moins un paramètre de batterie et à sortir une valeur de batterie (116) dépendant du paramètre de batterie, comprenant un circuit d'évaluation (42) servant à établir une valeur de batterie corrigée (126) à partir de la valeur de batterie (116) et d'une valeur de correction (84), et
comprenant un dispositif d'établissement de valeur de correction (70) qui est prévu pour déterminer la valeur de correction (84) dans le circuit d'évaluation,
**caractérisé en ce que** le dispositif d'établissement de valeur de correction détecte au moins une valeur d'influence d'un paramètre d'influence de la valeur de correction qui influence la valeur de correction (84), dans lequel, dans le dispositif d'établissement de valeur de correction (70), pour au moins deux plages de valeurs du paramètre d'influence, respectivement une règle d'affectation préétablie d'un facteur de correction (82, 86, 88, 90) est stockée pour le paramètre d'influence respectif (72, 74, 76), dans lequel la valeur de correction (84) est établie à l'aide des étapes suivantes consistant à :
a) détecter au moins une valeur d'influence du au moins un paramètre d'influence (72, 74, 76),
b) établir et sortir la plage de valeurs du paramètre d'influence (72, 74, 76) pour les valeurs d'influence (118, 120, 122) détectées,
c) sélectionner ladite au moins une règle d'affectation correspondant à la plage de valeurs,
d) déterminer et sortir le facteur de correction (82, 86, 88, 90) correspondant à la plage de valeurs du paramètre d'influence (72, 74, 76) à partir de la règle d'affectation, et
e) déterminer la valeur de correction (84) à l'aide du facteur de correction (82, 86, 88, 90).

2. Procédé selon la revendication 1, **caractérisé en ce que** les étapes a) à e) sont exécutées à plusieurs reprises.

3. Procédé selon l'une quelconque des revendications 1 et 2, **caractérisé en ce que** la règle d'affectation préétablie du facteur de correction (86, 88, 90) et du paramètre d'influence (72, 74, 76) représente un premier facteur d'influence (92, 94, 96) qui est indépendant du temps.

4. Procédé selon l'une quelconque des revendications précédentes, **caractérisé en ce que** la règle d'affectation préétablie du facteur de correction (86, 88, 90) et du paramètre d'influence (72, 74, 76) présente un deuxième facteur d'influence (98, 100, 102) qui est dépendant du temps, en particulier de la durée de fonctionnement totale du capteur de batterie (26), dans lequel en outre le temps, en particulier la durée de fonctionnement totale du capteur de batterie (26), est détecté, et le deuxième facteur d'influence (98, 100, 102) est déterminé en fonction du temps, en particulier de la durée de fonctionnement totale, et de la plage de valeurs du paramètre d'influence (72, 74, 76).

5. Procédé selon la revendication 4, **caractérisé en ce qu'**un premier facteur d'influence (92, 94, 96) indépendant du temps est corrigé à l'aide du deuxième facteur d'influence (98, 100, 102) en fonction du temps établi, en particulier de la durée de fonctionnement totale.

6. Procédé selon l'une quelconque des revendications précédentes, **caractérisé en ce que** les règles d'affectation préétablies du facteur de correction (86, 88, 90) et du paramètre d'influence (72, 74, 76) comprennent au moins deux courbes caractéristiques, en particulier un réseau de caractéristiques (104, 106, 108).

7. Procédé selon l'une quelconque des revendications précédentes, **caractérisé en ce qu'**au moins un paramètre d'influence (72, 74, 76) est un paramètre de batterie, en particulier un courant de batterie, une tension de batterie et/ou une température de batterie.

8. Procédé selon l'une quelconque des revendications précédentes, **caractérisé en ce qu'**au moins un paramètre d'influence (72, 74, 76) est indépendant de la batterie, étant en particulier une sollicitation mécanique.

9. Procédé selon l'une quelconque des revendications précédentes, **caractérisé en ce que** le paramètre d'influence (72, 74, 76) est détecté par un dispositif de détection (36, 44, 60) servant à détecter un paramètre de batterie.

10. Procédé selon l'une quelconque des revendications précédentes, **caractérisé en ce que** le paramètre d'influence (72, 74, 76) est détecté par un dispositif de détection de paramètre d'influence servant à détecter au moins un paramètre d'influence (72, 74, 76) et à sortir au moins une valeur d'influence au dispositif d'établissement de valeur de correction (70).

11. Procédé selon l'une quelconque des revendications précédentes, **caractérisé en ce que** dans le dispositif d'établissement de valeur de correction (70), pour plusieurs paramètres d'influence (72, 74, 76), respectivement au moins une règle d'affectation préétablie du facteur de correction (86, 88, 90) et du paramètre d'influence (72, 74, 76) est stockée, dans lequel un facteur de correction (86, 88, 90) est établi pour chaque paramètre d'influence (72, 74, 76).

12. Procédé selon la revendication 11, **caractérisé en ce qu'**à partir des facteurs de correction établis (86, 88, 90), un facteur de correction total (82) est établi qui permet de déterminer la valeur de correction (84).

13. Procédé selon l'une quelconque des revendications précédentes, **caractérisé en ce que** dans le dispositif d'établissement de valeur de correction (70), une valeur de correction initiale (78) est stockée qui est corrigée à l'aide du facteur de correction établi (82, 86, 88, 90).

14. Capteur de batterie (26), comprenant au moins un dispositif de détection (38, 44, 60) conçu pour détecter au moins un paramètre de batterie et pour sortir une valeur de batterie (116) dépendant du paramètre de batterie, comprenant un circuit d'évaluation (42) qui est conçu pour établir une valeur de batterie corrigée (126) à partir de la valeur de batterie (116) et d'une valeur de correction (84), et comprenant un dispositif d'établissement de valeur de correction (70) qui est prévu pour déterminer la valeur de correction (84) dans le circuit d'évaluation,
**caractérisé en ce que** le dispositif d'établissement de valeur de correction (70) est conçu pour détecter au moins une valeur d'influence d'un paramètre d'influence qui influence la valeur de correction (84), dans lequel le dispositif d'établissement de valeur de correction (70) est conçu pour stocker respectivement une règle d'affectation préétablie d'un facteur de correction (82, 86, 88, 90) pour au moins deux plages de valeurs du paramètre d'influence, et dans lequel le dispositif d'établissement de valeur de correction (70) est conçu pour établir la valeur de correction (84) à l'aide des étapes suivantes consistant à :
a) détecter au moins une valeur d'influence du au moins un paramètre d'influence (72, 74, 76),
b) établir et sortir la plage de valeurs du paramètre d'influence (72, 74, 76) pour les valeurs d'influence (118, 120, 122) détectées,
c) sélectionner ladite au moins une règle d'affectation correspondant à la plage de valeurs,
d) déterminer et sortir le facteur de correction (82, 86, 88, 90) correspondant à la plage de valeurs du paramètre d'influence (72, 74, 76) à partir de la règle d'affectation, et
e) déterminer la valeur de correction (84) à l'aide du facteur de correction (82, 86, 88, 90).
